# EUROPEAN PATENT SPECIFICATION

(11) **EP 4 573 860 B1**
(45) Date of publication and mention of the grant of the patent: **09.12.2026**
(21) Application number: 22764633.8
(22) Date of filing: 16.08.2022
(51) Int. Cl.: H10N 60/01, H10D 64/01, H10D 64/62

(54) **METHOD OF FABRICATING A SEMICONDUCTOR DEVICE USING MASKED DEPOSITION**
VERFAHREN ZUR HERSTELLUNG EINES HALBLEITERBAUELEMENTS MITTELS MASKIERTER ABSCHEIDUNG
PROCÉDÉ DE FABRICATION D'UN DISPOSITIF À SEMI-CONDUCTEUR PAR DÉPÔT À MASQUE

(43) Date of publication of application: 25.06.2025
(73) Proprietor: Microsoft Technology Licensing, LLC, Redmond, WA 98052-6399 (US)
(72) Inventor: VAN WOERKOM, David Johannes, Redmond, Washington 98052-6399 (US); GRIGGIO, Flavio, Redmond, Washington 98052-6399 (US); THIYAGARAJAH, Naganivetha, Redmond, Washington 98052-6399 (US); KLOSTER, Maren Elisabeth, Redmond, Washington 98052-6399 (US); UPADHYAY, Shivendra, Redmond, Washington 98052-6399 (US); KOSTAMO, Pasi, Redmond, Washington 98052-6399 (US)
(74) Representative: Page White Farrer
(86) International application number: PCT/US2022/075034
(87) International publication number: WO 2024/039396

(56) References cited:
- WO-A1-2013/010829
- US-A1- 2005 098 831
- US-B1- 10 366 884
- GILL S T ET AL: "Selective-Area Superconductor Epitaxy to Ballistic Semiconductor Nanowires", NANO LETTERS, vol. 18, 10 September 2018 (2018-09-10), pages 6121 - 6128, XP093033696, DOI: 10.1021/acs.nanolett.8b01534

## Description

### Background

Topological quantum computing is based on the phenomenon whereby non-abelian anyons, in the form of "Majorana zero modes" (MZMs), can be formed in regions where a semiconductor is coupled to a superconductor. A non-abelian anyon is a type of quasiparticle, meaning not a particle *per se,* but an excitation in an electron liquid that behaves at least partially like a particle. MZMs are a particular bound state of such quasiparticles.

Under certain conditions, MZMs can be formed close to an interface between a semiconductor and superconductor. For example, MZMs may be formed in a device comprising a semiconductor nanowire coated with a superconductor. A nanowire has a length which is many times greater than its diameter and can be considered as a 1-dimensional system. MZMs can also be formed in two-dimensional systems, comprising a superconductor coupled to a quantum well hosting a 2-dimensional electron gas, such as described by Suominen et al, Phys. Rev. Lett. 119, 176805 (2017) and Nichele et al, Phys. Rev. Lett. 119, 136803 (2017).

When MZMs are induced in a structure, the structure is said to be in the "topological regime". To induce this requires a magnetic field, conventionally applied externally, and also cooling of the structure to a temperature that induces superconducting behaviour in the superconductor material.

Topological devices are useful for creating a quantum bit which can be manipulated for the purpose of quantum computing. A quantum bit, also referred to as a qubit, is an element upon which a measurement with two possible outcomes can be performed, but which at any given time (when not being measured) can in fact be in a quantum superposition of the two states corresponding to the different outcomes.

To induce MZMs, the device is cooled to a temperature where the superconductor (e.g. aluminium, lead, indium, or another s-wave superconductor) exhibits superconducting behaviour. The superconductor causes a proximity effect in the adjacent semiconductor, whereby a region of the semiconductor near the interface with the superconductor also exhibits superconducting properties. It is in this region of the semiconductor where the MZMs are formed.

Another condition for inducing the topological phase where MZMs can form is the application of a magnetic field in order to lift the spin degeneracy in the semiconductor. Degeneracy in the context of a quantum system refers to the case where different quantum states have the same energy level. Lifting the degeneracy means causing such states to adopt different energy levels. Spin degeneracy refers to the case where different spin states have the same energy level. Spin degeneracy can be lifted by means of a magnetic field, causing an energy level spilt between the differently spin-polarized electrons. This is known as the Zeeman effect. Typically, the magnetic field is applied by an external electromagnet.

The behaviour of semiconductor-superconductor hybrid devices is highly dependent upon the quality of the semiconductor-superconductor interface. The quality of the interface is in turn determined by the method by which the device is fabricated. There is also a desire for fabrication methods which can be scaled up to allow larger or more complex devices with many qubits to be obtained.

US 10,366,884 B1 discloses a method for obtaining a semiconductor island including epitaxially growing a semiconductor structure over a substrate with a mask layer defining a region not covered by the mask layer, forming a filling layer over the semiconductor structure and the mask layer, and subsequently removing at least a portion of the semiconductor structure and filling layer that is located above the height of the mask layer.

US 2005/098831 A1 discloses a semiconductor device comprising: a semiconductor layer which is formed on an insulating film or on an insulating substrate while being surrounded by element-isolation insulating films, and includes a channel region and a source/drain region; a gate electrode which is formed on the channel region via a gate insulating film while being surrounded by sidewall insulating films; and an upheaved layer which is made of a conductive material and is formed on the source/drain region.

WO 2013/010829 A1 discloses a method of growing III-V epitaxial layers on a substrate, to a semiconductor substrate, to a device comprising the semiconductor structure, and to an electronic circuit comprising the device and/or the semiconductor structure. An enhancement-mode HEMT device is made by making an (In)AlGaN/GaN structure that is capped with a GaN/AlGaN/SiN protective layer stack. The SiN and AlGaN layers of the protective layer stack are etched away in a gate area of the structure, leaving the GaN layer intact. The GaN is re-evaporated and p-type (Al)GaN is re-grown selectively in the gate area of the structure.

Gill T. S. et al.: "Selective-Area Semiconductor Epitaxy Superconductor Nanowires", NANO LETTERS, vol. 18, 10 September 2018, pages 6121-6128 discloses the development of selective-area epitaxy of Al to InSb nanowires. Sulfur passivation and low-energy Ar ion milling are used to remove native oxides and absorbates respectively from the surface of the nanowire prior to Al epitaxy.

### Summary

The present invention provides a method of fabricating a semiconductor device according to claim 1. The method comprises: providing a workpiece comprising a substrate, a semiconductor component arranged on the substrate, a capping layer arranged on the semiconductor component, and a dielectric layer arranged on the capping layer; forming a mask by patterning the dielectric layer and the capping layer to form an opening, the opening exposing a portion of the semiconductor component, wherein the capping layer is a layer of arsenic or antimony; depositing a material onto the mask and onto the exposed portion of the semiconductor component via the opening in the mask; subsequently filling the opening with a sacrificial filler; and subsequently removing the material deposited onto the mask, wherein the sacrificial filler prevents removal of the material deposited onto the semiconductor component. The method is useful for fabricating semiconductor devices having a clean interface between the semiconductor component and the deposited material, as will be explained in more detail below.

### Brief Description of the Drawings

To assist understanding of embodiments of the present disclosure and to show how such embodiments may be put into effect, reference is made, by way of example only, to the accompanying drawings in which:
Fig. 1 is a schematic cross-section of an example workpiece on which methods provided herein may be practiced;
Fig. 2 is a flow diagram outlining a method of preparing a workpiece of the type shown in Fig. 1;
Fig. 3 is a flow diagram outlining a first example method of fabricating a semiconductor device;
Figs. 4A to 4E are schematic cross-sections of workpieces obtained at various stages of the method of Fig. 3;
Fig. 5 is a flow diagram outlining a second example method of fabricating a semiconductor device;
Fig. 6 is a schematic cross section of a product obtainable by the method of Fig. 5.

### Detailed Description

Directional terms such as "top", "bottom", "left", "right", "above", "below", "horizontal" and "vertical" are used herein for convenience of description and relate to the orientation shown in the drawings. For the avoidance of any doubt, this terminology is not intended to limit the orientation of the device in an external frame of reference. The substrate is taken to be the bottom of the device, regardless of how the device is oriented with respect to gravity.

As used herein, the term "superconductor" refers to a material which is capable of superconductivity when cooled to a temperature below a critical temperature, T_{c}, of the material. The use of this term is not intended to limit the temperature of the device.

A "semiconductor-superconductor hybrid structure" comprises a semiconductor component and a superconductor component which may become coupled to one another under certain operating conditions. In particular, this term refers to a structure capable of showing topological behaviour such as Majorana zero modes, or other excitations useful for quantum computing applications. The operating conditions generally comprise cooling the structure to a temperature below the Tc of the superconductor component, applying a magnetic field to the structure, and applying electrostatic gating to the structure. Generally, at least part of the semiconductor component is in intimate contact with the superconductor component, for example the superconductor component may be epitaxially grown on the semiconductor component. Certain device structures having one or more further components between the semiconductor component and superconductor component have however been proposed.

A high vacuum is an environment having a gas pressure of less than or equal to 100 mPa (0.75 mTorr). An ultra-high vacuum is an environment having a gas pressure of less than or equal to 100 nPa (0.75 nTorr).

A semiconductor surface may be described as pristine when it is in an "as-grown" state, substantially free of native oxides and contaminants.

One comparative process for fabricating semiconductor-superconductor hybrid devices is the *in situ* stencil window technique. In accordance with this technique, a semiconductor component is grown on a substrate in a vacuum environment. A stencil, also referred to as a shadow mask, is then positioned over the semiconductor component. The superconductor is deposited onto the semiconductor component through the stencil. The deposition is *in situ* in the sense that the substrate is not removed from the vacuum environment until after the deposition is completed.

*In situ* stencilling allows a clean interface between the semiconductor and the superconductor to be obtained. However, this technique has limited scalability: the maximum chip size is limited, and the deposition process is slow, often taking several hours. Additionally, *in situ* stencilling is not particularly flexible. Stencil masks must be manufactured in advance, which may add substantial lead time. There are also limitations on the deposition patterns which may be obtained. For example, a ring of superconductor is impossible to obtain using stencilling.

Another comparative process comprises growing a superconductor layer over a freestanding semiconductor nanowire *in situ* by molecular beam epitaxy. The molecular beam is angled with respect to the nanowire, such that superconductor is deposited only onto selected faces of the nanowire. The nanowire may be shadowed by other nanowires or by shadow walls to allow some additional control over the deposition of the superconductor. Post-processing steps are then performed. The post-processing steps include cleaving the nanowires from their growth substrate by sonication in a solvent, and transferring the nanowires to a target substrate. It has been found that the patterns of superconductor which can be deposited by this technique are limited, and that the post-processing steps are challenging and limit quality and reproducibility.

Still another comparative process involves *ex situ* deposition of the superconductor. A semiconductor nanowire is prepared, and transferred onto a target substrate which includes pre-patterned bottom gates and shadow walls. The surface of the nanowire is then cleaned to remove native oxides. Superconductor is then deposited onto the nanowire from an angled beam. The shadow walls allow for selective deposition of the superconductor. This process has limited scalability.

Provided herein are methods for fabricating semiconductor devices which may allow for improved scalability and/or flexibility while allowing a clean interface between the semiconductor and a further material. In the described methods, a mask is formed over a semiconductor component. A material is deposited over the mask, forming a desired pattern of material on the semiconductor component as well as a layer of excess material on the mask. The opening in the mask is then filled with a sacrificial filler, to allow the excess deposited material to be removed while protecting the desired pattern of material.

The mask comprises two layers: a lower layer, which is formed either *in situ* or directly after performing atomic hydrogen cleaning, and an upper layer. The lower layer is referred to herein as a capping layer or protective layer. The upper layer is referred herein to as a dielectric layer.

In accordance with the invention as defined in claim 1, the capping layer comprises arsenic or antimony. Arsenic and antimony sublime at relatively low temperatures when heated in a vacuum environment. This may allow the capping layer to be patterned without exposing the semiconductor component to an etchant. The use of arsenic and antimony may also allow the mask to be removed from the semiconductor component at the end of the process. It has been found that removing arsenic or antimony by heating in a vacuum does not damage the surface of the semiconductor component.

Although the present methods will be described with particular reference to the fabrication of semiconductor-superconductor hybrid devices, the methods are more generally useful for fabricating any type of semiconductor device having a clean interface between a semiconductor material and a further material.

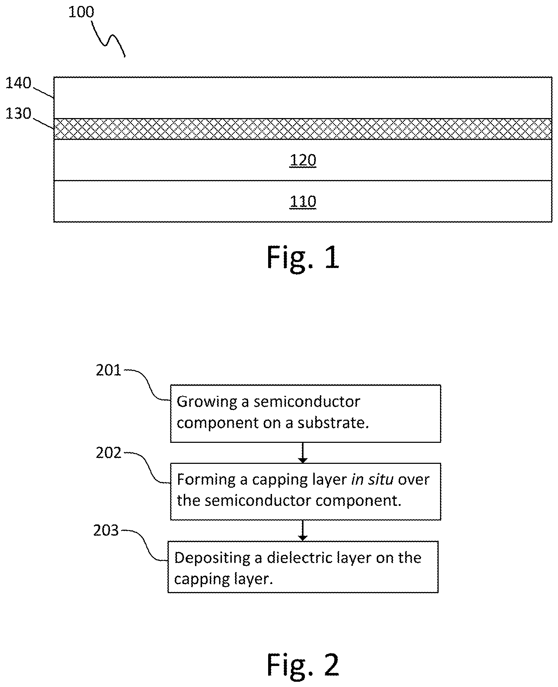

The methods provided herein begin by providing a workpiece 100 of the type illustrated in schematic cross-section in Fig. 1.

The workpiece 100 comprises a substrate 110, a semiconductor component 120 arranged on the substrate, a capping layer 130 arranged on the semiconductor component 120, and a dielectric layer 140 arranged on the capping layer 130.

The substrate 110 provides a base on which the semiconductor component 120 is grown. The nature of the substrate is not particularly limited, and may be selected as appropriate depending upon the nature of the semiconductor component to be formed. The substrate 110 typically comprises a wafer, i.e. a piece of single crystalline material. The substrate 110 may comprise a III-V semiconductor material, such as indium phosphide, indium antimonide, indium arsenide, gallium arsenide, or gallium antimonide. Other wafer materials, such as silicon, may be used.

The nature of the semiconductor component 120 is not particularly limited. The semiconductor component 120 is typically arranged epitaxially on the substrate. By way of illustration, the semiconductor component 120 may comprise a 2DEG or 2DHG structure, or one or more nanowires.

A 2DEG or 2DHG structure is a semiconductor heterostructure for hosting a two-dimensional electron gas or two-dimensional hole gas, respectively. An example of such a heterostructure comprises a lower barrier arranged epitaxially on the substrate; a quantum well arranged epitaxially on the lower barrier; and an upper barrier layer arranged epitaxially on the quantum well. The quantum well comprises a material which is different from the material(s) of the lower barrier and upper barrier. The materials of the lower barrier layer and the upper barrier layer may each be independently selected.

The quantum well may comprise a layer of semiconductor material which has a relatively small band gap compared to the materials of the upper and lower barriers. Illustrative materials useful for forming quantum wells are described in, for example, Odoh and Njapba, "A Review of Semiconductor Quantum Well Devices", Advances in Physics Theories and Applications, vol. 46, 2015, pp. 26-32; and S. Kasap, P. Capper (Eds.), "Springer Handbook of Electronic and Photonic Materials", DOI 10.1007/978-3-319-48933-9_40.

The quantum well is typically a few atomic layers thick. For example, the quantum well may have a thickness in the range 2 to 14 nm, optionally 7 to 8 nm. The configuration of the upper and lower barriers is not particularly limited provided that a 2-dimensional electron gas can be formed in the quantum well layer. The lower barrier may comprise one or more layers of one or more different materials. The upper barrier may comprise one or more layers of one or more different materials. Constructing a barrier from a plurality of layers may provide defect filtering, i.e. may reduce the effects of dislocations in the crystalline structure of the materials used. Alternatively or additionally, the plurality of layers may comprise a plurality of different materials, to allow for lattice matching between adjacent layers in order to facilitate growth of the layers.

A nanowire is an elongate portion of semiconductor having a nano-scale width, and a length-to-width ratio of at least 20, optionally at least 100, or at least 500, or at least 1000. A typical example of a nanowire has a width in the range 10 to 500 nm, optionally 50 to 100 nm or 75 to 125 nm. Lengths are typically of the order of micrometres, e.g. at least 1 µm, or at least 10 µm, or at least 25 µm.

Nanowires may be grown epitaxially by selective area growth ("SAG"), for example. In such implementations, a SAG mask may surround a base of the nanowires. The SAG mask may remain in the workpiece. The methods described herein are compatible with the presence of SAG masks.

The semiconductor material(s) used to form the semiconductor component 120 are not particularly limited. The semiconductor component 120 may for example comprise one or more III-V semiconductors, in particular a compound or allow comprising at least one group III element selected from indium, aluminium and gallium; and at least one group V element selected from arsenic, phosphorous, and antimony.

The III-V semiconductor material may, for example, be a material of Formula 1:

InAsₓSb₁₋ₓ (Formula 1)

where x is in the range 0 to 1. In other words, the semiconductor component may comprise indium antimonide (x=0), indium arsenide (x=1), or a ternary mixture comprising 50 % indium on a molar basis and variable proportions of arsenic and antimony (0 <x <1).

Another class of materials useful as the semiconductor component are II-VI semiconductor materials. Examples of II-VI semiconductor materials include cadmium telluride, mercury telluride, lead telluride and tin telluride.

Still further examples of useful semiconductor materials include silicon and graphene.

A capping layer 130 covers the semiconductor component 120. A capping layer may also be referred to as a protective layer. Capping layer 130 protects the surface of the semiconductor component 120 during subsequent operations performed on the workpiece 100. In particular, the capping layer 130 may prevent the formation of native oxides on the surface of the semiconductor component 120. Capping layer 130 may allow the workpiece to be removed from a vacuum environment and/or transferred between different apparatuses.

Capping layer 130 may be formed *in situ* on the semiconductor component. In such implementations, the capping layer is applied over the semiconductor component without removing the workpiece from the vacuum environment in which the semiconductor component is grown.

In other implementations, capping layer 130 may be formed *ex situ.* By *'ex situ'* is meant in any environment other than the environment in which the semiconductor component is grown. When the capping layer is formed *ex situ,* the surface of the semiconductor component is typically cleaned immediately before forming the capping layer, such that the surface of the semiconductor is in a pristine state before the capping layer is applied. Atomic hydrogen cleaning is one example of a technique for cleaning semiconductor components.

Still further implementations use a combination of *in situ* and *ex situ* techniques to form the capping layer 130. In such implementations, a temporary capping layer is formed *in situ.* The workpiece is then transferred to a second environment. In the second environment, the temporary capping layer is removed and capping layer 130 is formed. The temporary capping layer comprises arsenic or antimony, and the capping layer comprises a dielectric material. Cleaning the semiconductor component before forming the capping layer 130 is optional, since the temporary capping layer prevents the formation of native oxides when the workpiece is transferred between environments.

Capping layer 130 is a layer of arsenic or antimony, particularly when capping layer 130 is formed *in situ.* Arsenic and antimony have similar properties to one another. Both materials have been found to provide very good protection for semiconductor surfaces, and each sublime at moderate temperatures in a vacuum environment, allowing them to be removed without requiring the use of an etchant. Arsenic has a sublimation temperature which is slightly lower than that of antimony, and may therefore be preferred in some implementations, for example if the semiconductor component is temperature-sensitive.

A dielectric layer 140 covers the capping layer 130. Dielectric layer 140 may be formed *ex situ,* i.e. after removing the workpiece from the vacuum environment in which the semiconductor component 120 is grown and capping layer 130 is applied. *In situ* formation of dielectric layer 140 is also contemplated.

Examples of suitable materials for dielectric layer 140 include oxides, such as aluminium oxides, hafnium oxides, silicon oxides, titanium oxides, tantalum oxides, zirconium oxides, or lanthanum oxides; and nitrides, such as silicon nitrides.

Various modifications may be made to the workpiece 100 of Fig. 1.

Additional components may be present. For example, the workpiece may incorporate gate electrodes, which may be buried in the substrate 110. Semiconductor component 120 is illustrated as a single layer; in some implementations, two or more semiconductor layers may be present. One or more further *in situ* layers may be provided between the substrate 110 and the capping layer 130. Dielectric layer 140 may be a stack of layers of one or more dielectric material(s).

Since the semiconductor component 120 of workpiece 100 is protected by capping layer 130 and dielectric layer 140, the workpiece 100 may be prepared in advance of carrying out the fabrication methods provided herein.

An example method for preparing the workpiece 100 will now be described with reference to Fig. 2, which is a flow diagram outlining the method.

At block 201, semiconductor component 120 is grown on substrate 110. This operation may comprise any appropriate epitaxial growth process. Illustrative examples of epitaxial growth processes include molecular beam epitaxy processes and chemical vapour deposition processes such as metalorganic vapour phase epitaxy (also referred to as metalorganic chemical vapour deposition). In implementations where multiple semiconductor materials are used, more than one epitaxial growth process may be used.

Semiconductor may be grown over substantially the entire surface of substrate 110, or may be grown only on selected regions, for example using selective area growth.

The operations of this block may comprise growing additional *in situ* components, depending upon the configuration of the desired device. Examples of such additional components may include, for example, a ferromagnetic insulator, or a material selected to increase spin-orbit interactions and/or to modify superconductivity within the finished device.

As will be appreciated, semiconductor growth is performed in a vacuum environment, often an ultra-high vacuum.

Then, at block 202, a capping layer 130 is formed over the semiconductor component 120.

As described above, the capping layer 130 may be formed *in situ, ex situ,* or by a combination of *in situ* and *ex situ* techniques.

In the example illustrated in Fig. 2, the capping layer 130 is formed *in situ* over the semiconductor component 120. In other words, the capping layer is formed without removing the semiconductor component from the vacuum environment in which the semiconductor component was grown.

To this end, the operations of blocks 201 and 202 are performed in the same apparatus in this example. The apparatus may comprise a single vacuum chamber. Alternatively, the apparatus may include two or more vacuum chambers and blocks 201 and 202 may be carried out in respective ones of the vacuum chambers, provided that the substrate is not exposed to the atmosphere until after capping layer is formed.

Forming the capping layer may comprise depositing material over the semiconductor component. For example, elemental arsenic may be deposited directly onto the semiconductor component.

In other implementations, forming the capping layer may comprise depositing a precursor over the semiconductor component, and then performing a reaction to form the capping layer. In a reference example not in accordance with the present claims, to form an aluminium oxide layer, a layer of aluminium may be grown over the semiconductor component, and then treated with an oxidising agent (e.g., dioxygen gas and/or ozone gas).

When the semiconductor component includes a compound or alloy of arsenic or antimony, the arsenic or antimony source used in the growth of the semiconductor component may conveniently also be used for the formation of the capping layer.

It may be desirable to form the capping layer at as low a temperature as possible. Layers of arsenic and antimony may be formed at relatively low temperatures in a vacuum environment.

After forming the capping layer, a dielectric layer 140 is deposited on the capping layer 130, at block 203.

Dielectric layer 140 may be formed *in situ.* Alternatively, since the semiconductor component is protected by the capping layer 130, dielectric layer 140 may be formed *ex situ.* Forming the dielectric layer 140 *ex situ* may allow for a wider range of processing conditions to be used when forming the dielectric layer 140.

Any appropriate technique may be used to form dielectric layer 140.

The thicknesses of the capping layer and dielectric layer may be selected as appropriate. In the methods described further below, at least portions of the capping layer and dielectric layer are removed. Thinner layers are typically easier to remove than thicker layers. By way of illustration, the capping layer and dielectric layer may each have respective thicknesses in the range 3 to 15 nm.

Various modifications may be made to the method of Fig. 2.

In the example, capping layer 130 is formed *in situ.* Capping layer 130 may alternatively be formed *ex situ,* or by a combination of *in situ* and *ex situ* processes.

In an *ex situ* process, the substrate 110 and semiconductor component 120 are removed from the environment in which the semiconductor component is grown. The capping layer is formed subsequently. If the semiconductor component is exposed to oxygen gas, e.g. in the air, then the surface of the semiconductor component is cleaned by atomic hydrogen cleaning before applying the capping layer.

In a combination *in situ* and *ex situ* process, a temporary capping layer of arsenic or antimony is applied *in situ.* The workpiece is transferred to another environment. The temporary capping layer is removed in the other environment, by heat or atomic hydrogen cleaning. Then, the capping layer is formed.

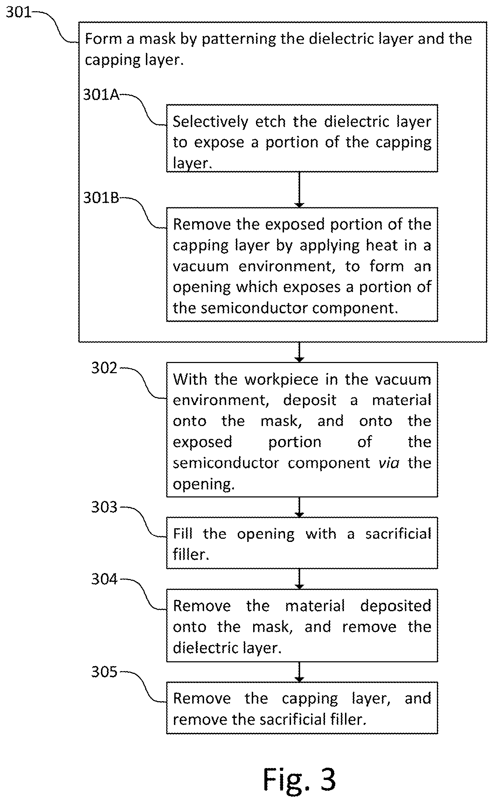

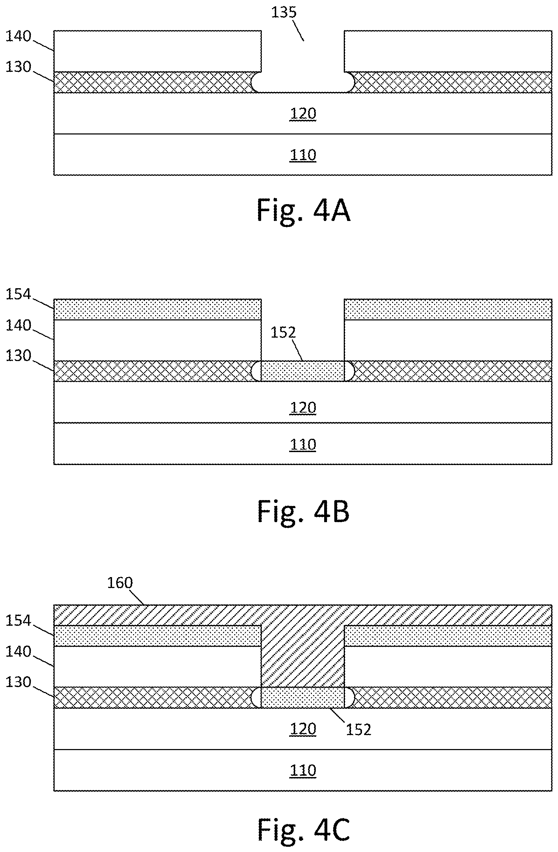

A first example method of fabricating a semiconductor device from a workpiece 100 of the type shown in Fig. 1 will now be explained with reference to Figs. 3 and 4A to 4E. Fig. 3 is a flow diagram outlining the method. Figs. 4A to 4E are schematic cross sections of workpieces obtained at various stages.

The method of Fig. 3 is suitable for processing workpieces having a capping layer which is removable by heat in a vacuum, e.g. an arsenic or antimony capping layer.

The method involves forming a mask by patterning the dielectric layer and capping layer; depositing a material over the mask; filling openings in the mask with a sacrificial filler; and removing the mask and sacrificial filler.

At block 301, a mask is formed by patterning dielectric layer 140 and capping layer 130 to form an opening 135 which exposes a portion of semiconductor component 120, as illustrated in Fig. 4A.

The mask may be formed in two stages 301A, 301B.

At block 301A, the dielectric layer 140 is patterned to expose a portion of the capping layer 130. Patterning the dielectric layer comprises a performing a lithographic process, such as electron beam lithography or photolithography. Examples of suitable photolithographic processes include deep ultraviolet ("DUV") lithography, extreme ultraviolet ("EUV") lithography, and immersion lithography. A suitable resist is applied, selectively exposed, and then developed to form a lithographic mask. An etch is performed to remove exposed portions of the dielectric layer without etching through the capping layer.

The capping layer 130 prevents the semiconductor component 120 from being exposed to the etchant used to pattern the dielectric layer 140.

The etch is typically a dry etch, using a gaseous etchant. Examples of dry etching techniques include inductively-coupled plasma etching ("ICP"), reactive ion etching ("RIE"), and ion beam etching ("IBE"). Examples of gaseous etchants include CF₄, SF₆, CHF₃, Cl₂, O₂, Ar, and combinations thereof.

Alternatively, the etch may be a wet etch.

After patterning the dielectric layer 140, the workpiece is transferred to a vacuum environment of an apparatus. The apparatus will be used to pattern the capping layer 130 at block 301B, and then to deposit a material over the semiconductor component at subsequent block 302. The apparatus may comprise a molecular beam epitaxy chamber.

The lithographic mask may be removed after patterning the dielectric layer and before transferring the workpiece to the vacuum environment.

The operations of block 301B comprise removing the portion of the capping layer 130 which was exposed at block 301A. This forms a mask, made up of capping layer 130 and dielectric layer 140 with an opening 135 which exposes a portion of semiconductor component 120. An example workpiece obtainable at this stage is illustrated in Fig. 4A.

According to the present invention, capping layer 130 is a layer of arsenic or antimony. Arsenic and antimony may each be removed by heat in a vacuum environment. This causes the arsenic or antimony to sublime. Arsenic and antimony each sublime at relatively low temperatures when heated in a vacuum, for example at temperatures of less than about 350 °C. It has been found that removing arsenic or antimony in this way does not damage the underlying surface of the semiconductor component 120.

Alternatively, the exposed portions of the capping layer 130 may be removed by atomic hydrogen cleaning. Atomic hydrogen cleaning may be performed at or below room temperature (e.g., at a temperature in the range 18 to 30 °C, or at a temperature below 18 °C).

After forming the mask, the method proceeds to block 302, in which a material is deposited onto the mask and onto the exposed portion of the semiconductor component 120 *via* the opening 135. This yields a workpiece as illustrated in Fig. 4B, which shows patterned material 152 on the semiconductor component, and excess material 154 on the dielectric layer 140.

The material may be deposited by molecular beam epitaxy, chemical vapour deposition, sputtering, or the like.

The deposition of the material is performed in the same apparatus as the formation of the opening in the capping layer 130, without exposing the surface of the semiconductor component 120 to the atmosphere. This maintains the surface of the semiconductor component 120 in a pristine state. For example, the formation of the opening may be performed in the same vacuum chamber as the deposition. Alternatively, if the apparatus is a cluster tool, the opening may take place in a cleaning chamber of the apparatus, before transferring the workpiece to a deposition chamber of the apparatus.

The further material may be selected based on the nature of the device to be fabricated.

The further material may comprise a metal. The patterned material 152 may, for example, form one or more electrodes.

The metal may be a superconductor. The patterned material 152 may be the superconductor component of a semiconductor-superconductor hybrid device. The superconductor may be an s-wave superconductor. Examples of s-wave superconductors include aluminium, indium, tin, and lead, with aluminium being preferred in some contexts. Aluminium has been found to couple well to III-V semiconductors, including those of Formula 1.

The deposited material may comprise other materials, such as a ferromagnetic insulator.

By controlling the deposition using the mask, a pattern 152 having smooth edges may be obtained. This may reduce disorder in the resulting device, in comparison with a device in which deposited material is patterned by etching. Disorder can negatively affect the performance of semiconductor-superconductor hybrid devices in particular. Without wishing to be bound by theory, it is believed that disorder may create unwanted sub-gap states which may in turn make the desired excitations more difficult to generate and/or observe.

Furthermore, the method may be more flexible than stencilling and shadowing approaches. Forming a mask using lithography may avoid the need to prepare a stencil or shadow walls in advance, and/or may allow a wider range of patterns to be defined.

In the illustrated example, a single layer of material is deposited. In variants, two or more layers comprising any number of different materials may be deposited. For example, depositing the material may comprise depositing a ferromagnetic insulator and then depositing a superconductor.

Following deposition of the material, the opening 135 in the mask is filled with a sacrificial filler 160 at block 303, to obtain a workpiece as illustrated in Fig. 4C.

Sacrificial filler 160 protects the patterned material 152, and the interface between the patterned material 152 and semiconductor component 120, during subsequent processing.

The sacrificial filler may be a planarizing material. Examples of planarizing materials include spin-on glass, spin-on carbon, a polymer, or a resist. The sacrificial filler may be applied by spin-coating.

The sacrificial filler covers the top surface of the workpiece.

After applying the sacrificial filler, the portion of the sacrificial filler 160 which covers the excess deposited material 154 is removed to expose the excess material 154, for example by plasma etching.

The portion of the sacrificial filler which covers the patterned material 152 has a thickness which greater than that of the portion of the sacrificial filler which covers the excess material. The etch is stopped before exposing the patterned material 152.

Then, the excess deposited material 154 is removed.

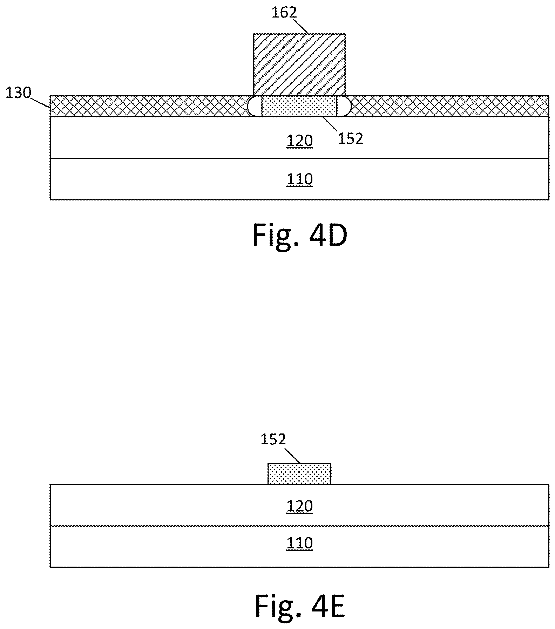

The dielectric layer 140 may also be removed, either completely or in part. In the illustrated example, both the excess material 154 and the dielectric layer 140 are removed at block 304, yielding a workpiece as illustrated in Fig. 4D.

Then, at block 305, the capping layer and remaining sacrificial filler may be removed, to provide a workpiece as illustrated in Fig. 4E.

Removing the capping layer 130 may comprise heating the capping layer 130 in a vacuum, as previously described with reference to block 301B. The temperature of the semiconductor may be maintained at or below 375°C during removal of the capping layer, because some semiconductor materials are damaged by exposure to high temperatures.

Alternatively, removing the capping layer 130 may comprise performing atomic hydrogen cleaning.

The conditions used to remove the sacrificial filler may be selected as appropriate depending upon the nature of the sacrificial filler. The sacrificial filler may be removed by plasma ashing or by a selective chemical clean. For example, carbon-based materials such as spin-on carbon may be removed by plasma ashing using oxygen. In another example, the sacrificial filler comprises TiN and is removed by an APM clean. An APM clean uses a mixture of ammonium hydroxide, hydrogen peroxide, and water.

In variants, the dielectric layer 140 and capping layer 130 may be removed in a single operation, rather than in two operations as in the described example.

After removal of the protective layer and sacrificial layer, one or more post-processing operations may be performed. By way of illustration, the structure may be covered with a dielectric, and gate electrodes may be added.

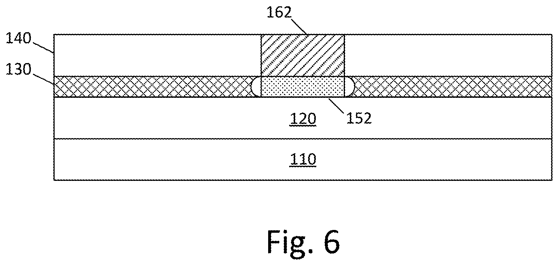

In variants, as an alternative to removing the dielectric layer and capping layer, only the excess deposited material and the portion of the sacrificial filler covering the excess deposited material are removed, and the workpiece is planarized. Such variants yield products of the type shown in Fig. 6.

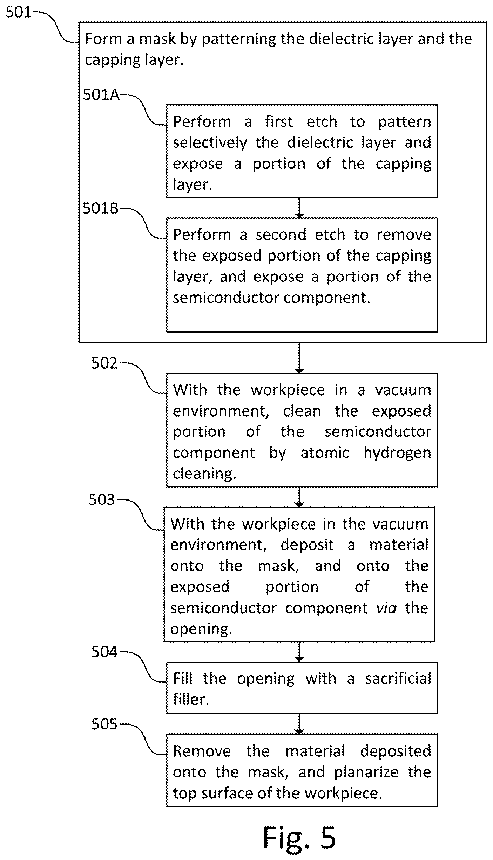

A second example method of fabricating a semiconductor device will now be explained with reference to the flow diagram of Fig. 5.

The method of Fig. 5 is a variant of the method of Fig. 3, and is suitable for processing workpieces of the type shown in Fig. 1 in which the capping layer 130 comprises a dielectric material.

The method of Fig. 5 differs from that of Fig. 3 in that the opening in the capping layer is formed by etching. After etching the capping layer, an additional cleaning step is performed to restore the exposed surface of the semiconductor component to a pristine state.

Fig. 5 also illustrates some alternative post-deposition operations.

The method begins with a workpiece of the type illustrated in Fig. 1, in which the capping layer is a dielectric layer.

At block 501, a mask is formed by patterning the dielectric layer and the capping layer. The patterning is performed in two stages 501A, 501B.

The first stage 501A may be as described with reference to block 301A of Fig. 3.

Then, in a second stage 501B, a second etch is performed to remove the exposed portion of the capping layer. The second etch exposes a portion of the semiconductor component 120. The patterned dielectric layer may serve as a mask for controlling the second etch.

In implementations where a lithographic mask is used to control the first etch, the lithographic mask may be removed between the first etch and the second etch, or after the second etch.

Different conditions, e.g. different etchants, are used for the first etch 501A and the second etch 501B. The first etch selectively etches the dielectric layer, without etching through the capping layer. The second etch selectively etches the exposed portion of the capping layer, without etching the material of the dielectric layer or the semiconductor component.

Any appropriate combination of etching conditions may be used.

In implementations not in accordance with the present claims where the capping layer is a layer of aluminium oxide and the dielectric layer is a layer of silicon nitride, the first etch may be a plasma dry etch using BCl₃ and the second etch may be a fluorine-based dry etch or a wet etch with e.g. potassium hydroxide.

In implementations not in accordance with the present claims where the capping layer is a layer of aluminium oxide and the dielectric layer is a layer of aluminium oxide, the first etch may be a fluorine-based dry etch using e.g. SF₆ or CF₄, and the second etch may be a wet etch using e.g. potassium hydroxide or tetramethylammonium hydroxide.

The exposed portions of the semiconductor component come into contact with the etchant used for the second etch, and will also be exposed to the atmosphere in which the etch is performed. Native oxide may form on the surface of the semiconductor oxide in the exposed portions. To restore the surface of these portions to a pristine state, the workpiece is transferred to a vacuum environment and the exposed portion of the semiconductor component is cleaned by atomic hydrogen cleaning, at block 502. It has been found that atomic hydrogen cleaning provides a high-quality surface.

The second etch may form an undercut extending underneath the dielectric layer. Such an undercut may be useful when depositing a superconductor component.

Subsequently, at block 503, a material is deposited onto the mask and onto the exposed portion of the semiconductor component via the opening in the mask. The deposition may be as previously described with reference to block 302 of Fig. 3.

The cleaning and deposition operations 502, 503 may both be performed in the same apparatus, under vacuum. Any appropriate apparatus may be used, provided that the cleaning and the deposition can be performed without exposing the workpiece to the atmosphere. The apparatus may include a molecular beam epitaxy chamber. In some implementations, the apparatus may be a cluster tool having dedicated cleaning and metal deposition chambers.

After depositing the material, the opening in the mask is filled with a sacrificial filler at block 504. This may be performed as described with reference to block 303 of Fig. 3.

In the illustrated example, at block 505, the excess material deposited onto the mask is removed, and the workpiece is planarized to produce a workpiece as illustrated in Fig. 6. In this example, the dielectric layer 140, protective layer 130, and a portion of sacrificial filler 162 remain in the product.

Post-fabrication operations, such as adding gate electrodes, may then be performed.

Various modifications may be made to the described methods.

For example, the operations of blocks 304 and 305 of Fig. 3 are optional, and may be omitted or replaced with a planarization process as described with reference to block 505 of Fig. 5.

It will be appreciated that the above embodiments have been described by way of example only.

More generally, according to the invention disclosed herein, there is provided a method of fabricating a semiconductor device. The method comprises: providing a workpiece comprising a substrate, a semiconductor component arranged on the substrate, a capping layer arranged on the semiconductor component, and a dielectric layer arranged on the capping layer; forming a mask by patterning the dielectric layer and the capping layer to form an opening, the opening exposing a portion of the semiconductor component; depositing a material onto the mask and onto the exposed portion of the semiconductor component via the opening in the mask; subsequently filling the opening with a sacrificial filler; and subsequently removing the material deposited onto the mask, wherein the sacrificial filler prevents removal of the material deposited onto the semiconductor component, and wherein the capping layer is a layer of arsenic or antimony.

The capping layer may be an *in situ* layer, in other words, a layer obtainable in an environment in which the semiconductor component is grown without removing the semiconductor component from the environment. A workpiece with an *in situ* capping layer may be distinguishable from a workpiece with an *ex situ* capping layer. An *in situ* layer of a material may have different physical properties to an *ex situ* layer of the same material. The surface of the semiconductor component having an *in situ* capping layer may be free of native oxides of the semiconductor material.

Providing the workpiece may comprise growing the semiconductor component on a substrate; forming the capping layer *in situ* on the semiconductor component; and depositing the dielectric layer onto the capping layer. By "forming the capping layer *in situ"* is meant that the semiconductor component and capping layer are both formed under vacuum in the same apparatus, without removing the substrate from the vacuum environment. The dielectric layer may be formed *in situ* or *ex situ.*

As an alternative to forming the capping layer *in situ,* the capping layer may be formed *ex situ.* In such implementations, the semiconductor component may be cleaned by atomic hydrogen cleaning immediately before forming the capping layer.

Patterning the dielectric layer may comprise patterning the dielectric layer under a first set of conditions to expose a portion of the capping layer, and subsequently removing the exposed portion of the capping layer under a second set of conditions. The capping layer may protect the semiconductor component from the first set of conditions, thereby reducing or avoiding damage to the surface of the semiconductor component.

The first set of conditions typically comprises a first etch, controlled by a lithographic mask. The first etch may be a dry etch. The capping layer protects the semiconductor component from the first set of conditions. The lithographic mask may be removed, and the capping layer may protect the semiconductor component from conditions used to remove the lithographic mask.

The second set of conditions may be selected depending upon the nature of the capping layer.

The capping layer is a layer of arsenic or antimony. Arsenic and antimony layers may be effective for protecting the surface of the semiconductor component, may be formed at relatively low temperatures, and may be removed without damaging the surface of the semiconductor component.

The capping layer is a layer of arsenic or antimony, and patterning the dielectric layer and the capping layer may comprise selectively etching the dielectric layer to expose a portion of the capping layer; and subsequently removing the exposed portion of the capping layer by applying heat in a vacuum environment.

In such implementations, the workpiece may be transferred to the vacuum environment after selectively etching the dielectric layer and before removing the exposed portion of the capping layer. The workpiece may be maintained in the vacuum environment until after the deposition of the material.

The capping layer is a layer of arsenic or antimony, and the method typically does not comprise a cleaning operation between the removal of the capping layer and the deposition of the material. Arsenic and antimony may be removed without damaging the surface of the semiconductor component, which may make cleaning unnecessary.

The capping layer is a layer of arsenic or antimony, the method may further comprise, after filling the opening with the sacrificial filler: removing the dielectric layer to expose the capping layer; and removing the capping layer by applying heat in a vacuum environment. The capping layer may protect the semiconductor component during removal of the dielectric layer, and the use of arsenic or antimony as the capping layer may allow for easy removal of the capping layer.

In implementations where the capping layer is removed, the method may comprise, after removing the dielectric layer, removing the sacrificial filler. Removal of the dielectric layer, capping layer, and optionally sacrificial filler may be desirable when fabricating certain devices.

As one possible alternative to removing the dielectric layer and capping layer, the surface of the workpiece may be planarized after filling the opening with the sacrificial filler. Planarization may allow for gate electrodes and/or other ancillary components to be added to the workpiece.

In implementations which include cleaning the exposed portion of the semiconductor component, the workpiece may be transferred to a vacuum environment after performing the second etch and before the cleaning. The workpiece may then be maintained in the vacuum environment until after the deposition of the material. Performing the cleaning and deposition in the same vacuum environment may allow a high-quality interface between the semiconductor component and the deposited material to be obtained, by avoiding damage to the semiconductor component after the cleaning.

Removing the material deposited onto the mask may comprise planarizing a surface of the workpiece. Planarizing the surface may make post-processing operations, such as adding gate electrodes or the like, easier.

The sacrificial filler may, for example, comprise spin-on glass or spin-on carbon. Other polymers or resists may be used as the sacrificial filler.

The semiconductor component may comprise a semiconductor heterostructure for hosting a 2-dimensional electron gas or a 2-dimensional hole gas.

The semiconductor component may comprise a III-V semiconductor material. The III-V semiconductor material may be a material of Formula 1, as defined hereinabove.

The deposited material may comprise a metal, optionally a superconductor. The superconductor may be aluminium.

Other variants or use cases of the disclosed techniques may become apparent to the person skilled in the art once given the disclosure herein. The scope of the disclosure is not limited by the described embodiments but only by the accompanying claims.

## Claims

1. A method of fabricating a semiconductor device, which method comprises:
providing a workpiece (100) comprising a substrate (110), a semiconductor component (120) arranged on the substrate (110), a capping layer (130) arranged on the semiconductor component (120), and a dielectric layer (140) arranged on the capping layer (130);
forming (301) a mask by patterning the dielectric layer (140) and the capping layer (130) to form an opening (135), the opening (135) exposing a portion of the semiconductor component (120);
depositing (302) a material (152, 154) onto the mask and onto the exposed portion of the semiconductor component (120) via the opening (135) in the mask;
subsequently filling (303) the opening (135) with a sacrificial filler (160); and
subsequently removing (304) the material (154) deposited onto the mask, wherein the sacrificial filler (160) prevents removal of the material (152) deposited onto the semiconductor component (120);
wherein the capping layer (130) is a layer of arsenic or antimony.

2. The method according to claim 1, wherein patterning the dielectric layer and the capping layer comprises:
selectively etching the dielectric layer (140) to expose a portion of the capping layer (130); and
subsequently removing the exposed portion of the capping layer (130) by applying heat in a vacuum environment.

3. The method according to claim 2, wherein:
the workpiece is transferred to the vacuum environment after selectively etching the dielectric layer (140) and before removing the exposed portion of the capping layer (130); and
the workpiece is maintained in the vacuum environment until after the deposition of the material (152, 154).

4. The method according to any of claims 1 to 3, further comprising, after filling the opening (135) with the sacrificial filler (160):
removing the dielectric layer (140) to expose the capping layer (130); and
removing the capping layer (130) by applying heat in a vacuum environment.

5. The method according to claim 4, further comprising, after removing the dielectric layer (140), removing the sacrificial filler (162).

6. The method according to any preceding claim, wherein providing the workpiece comprises:
growing (201) the semiconductor component (120) on the substrate (110);
forming (202) the capping layer (130) *in situ* on the semiconductor component (120);
and
depositing (203) the dielectric layer (140) onto the capping layer (130);
optionally wherein the dielectric layer (140) is deposited *ex situ.*

7. The method according to any preceding claim, wherein removing the material (154) deposited onto the mask comprises planarizing a surface of the workpiece.

8. The method according to any preceding claim, wherein the sacrificial filler (160) comprises a planarizing material.

9. The method according to any preceding claim, wherein the semiconductor component (120) comprises a semiconductor heterostructure for hosting a 2-dimensional electron gas or a 2-dimensional hole gas.

10. The method according to any preceding claim, wherein:
the semiconductor component (120) comprises a III-V semiconductor material; and/or
the deposited material (152, 154) comprises a superconductor.

## Patentansprüche

1. Verfahren zum Herstellen einer Halbleitervorrichtung, das Verfahren umfassend:
Bereitstellen eines Werkstücks (100), umfassend ein Substrat (110), eine auf dem Substrat (110) angeordnete Halbleiterkomponente (120), eine auf der Halbleiterkomponente (120) angeordnete Deckschicht (130) und eine auf der Deckschicht (130) angeordnete dielektrische Schicht (140);
Bilden (301) einer Maske durch Strukturieren der dielektrischen Schicht (140) und der Deckschicht (130), um eine Öffnung (135) zu bilden, wobei die Öffnung (135) einen Abschnitt der Halbleiterkomponente (120) freilegt;
Abscheiden (302) eines Materials (152, 154) auf der Maske und auf dem freigelegten Abschnitt der Halbleiterkomponente (120) über die Öffnung (135) in der Maske;
anschließendes Füllen (303) der Öffnung (135) mit einem Opferfüllstoff (160); und
anschließendes Entfernen (304) des auf der Maske abgeschiedenen Materials (154), wobei der Opferfüllstoff (160) ein Entfernen des auf der Halbleiterkomponente (120) abgeschiedenen Materials (152) verhindert;
wobei die Deckschicht (130) eine Schicht aus Arsen oder Antimon ist.

2. Verfahren nach Anspruch 1, wobei das Strukturieren der dielektrischen Schicht und der Deckschicht umfasst:
selektives Ätzen der dielektrischen Schicht (140), um einen Abschnitt der Deckschicht (130) freizulegen; und
anschließendes Entfernen des freigelegten Abschnitts der Deckschicht (130) durch Anwenden von Wärme in einer Vakuumumgebung.

3. Verfahren nach Anspruch 2, wobei:
das Werkstück nach dem selektiven Ätzen der dielektrischen Schicht (140) und vor dem Entfernen des freigelegten Abschnitts der Deckschicht (130) in die Vakuumumgebung überführt wird; und
das Werkstück bis nach der Abscheidung des Materials (152, 154) in der Vakuumumgebung gehalten wird.

4. Verfahren nach einem der Ansprüche 1 bis 3, ferner umfassend, nach dem Füllen der Öffnung (135) mit dem Opferfüllstoff (160):
Entfernen der dielektrischen Schicht (140), um die Deckschicht (130) freizulegen; und
Entfernen der Deckschicht (130) durch Anwenden von Wärme in einer Vakuumumgebung.

5. Verfahren nach Anspruch 4, ferner umfassend, nach dem Entfernen der dielektrischen Schicht (140), das Entfernen des Opferfüllstoffs (162).

6. Verfahren nach einem der vorstehenden Ansprüche, wobei das Bereitstellen des Werkstücks umfasst:
Aufwachsen (201) der Halbleiterkomponente (120) auf dem Substrat (110);
Bilden (202) der Deckschicht (130) *in situ* auf der Halbleiterkomponente (120); und
Abscheiden (203) der dielektrischen Schicht (140) auf der Deckschicht (130); wobei optional die dielektrische Schicht (140) *ex situ* abgeschieden wird.

7. Verfahren nach einem der vorstehenden Ansprüche, wobei das Entfernen des auf der Maske abgeschiedenen Materials (154) das Planarisieren einer Oberfläche des Werkstücks umfasst.

8. Verfahren nach einem der vorstehenden Ansprüche, wobei der Opferfüllstoff (160) ein planarisierendes Material umfasst.

9. Verfahren nach einem der vorstehenden Ansprüche, wobei die Halbleiterkomponente (120) eine Halbleiter-Heterostruktur zum Aufnehmen eines 2-dimensionalen Elektronengases oder eines 2-dimensionalen Lochgases umfasst.

10. Verfahren nach einem der vorstehenden Ansprüche, wobei:
die Halbleiterkomponente (120) ein III-V-Halbleitermaterial umfasst; und/oder
das abgeschiedene Material (152, 154) einen Supraleiter umfasst.

## Revendications

1. Procédé de fabrication d'un dispositif à semi-conducteur, lequel procédé comprend :
la fourniture d'une pièce à usiner (100) comprenant un substrat (110), un composant à semi-conducteur (120) agencé sur le substrat (110), une couche de recouvrement (130) agencée sur le composant à semi-conducteur (120), et une couche diélectrique (140) agencée sur la couche de recouvrement (130) ;
la formation (301) d'un masque par structuration de la couche diélectrique (140) et de la couche de recouvrement (130) pour former une ouverture (135), l'ouverture (135) exposant une partie du composant semi-conducteur (120) ;
le dépôt (302) d'un matériau (152,154) sur le masque et sur la partie exposée du composant à semi-conducteur (120) par le biais de l'ouverture (135) dans le masque ;
le remplissage (303) ultérieur de l'ouverture (135) avec un matériau de remplissage sacrificiel (160) ; et
le retrait (304) ultérieur du matériau (154) déposé sur le masque, dans lequel le matériau de remplissage sacrificiel (160) empêche le retrait du matériau (152) déposé sur le composant à semi-conducteur (120) ;
dans lequel la couche de recouvrement (130) est une couche d'arsenic ou d'antimoine.

2. Procédé selon la revendication 1, dans lequel la structuration de la couche diélectrique et de la couche de recouvrement comprend :
la gravure sélective de la couche diélectrique (140) pour exposer une partie de la couche de recouvrement (130) ; et
le retrait ultérieur de la partie exposée de la couche de recouvrement (130) par application de chaleur dans un environnement sous vide.

3. Procédé selon la revendication 2, dans lequel :
la pièce à usiner est transférée vers l'environnement sous vide après la gravure sélective de la couche diélectrique (140) et avant le retrait de la partie exposée de la couche de recouvrement (130) ; et
la pièce à usiner est maintenue dans l'environnement sous vide jusqu'après le dépôt du matériau (152,154).

4. Procédé selon l'une quelconque des revendications 1 à 3, comprenant en outre, après le remplissage de l'ouverture (135) avec le matériau de remplissage sacrificiel (160) :
le retrait de la couche diélectrique (140) pour exposer la couche de recouvrement (130) ; et
le retrait de la couche de recouvrement (130) par application de chaleur dans un environnement sous vide.

5. Procédé selon la revendication 4, comprenant en outre, après le retrait de la couche diélectrique (140), le retrait du matériau de remplissage sacrificiel (162).

6. Procédé selon l'une quelconque revendication précédente, dans lequel la fourniture de la pièce à usiner comprend :
la croissance (201) du composant à semi-conducteur (120) sur le substrat (110) ;
la formation (202) de la couche de recouvrement (130) *in situ* sur le composant à semi-conducteur (120) ; et
le dépôt (203) de la couche diélectrique (140) sur la couche de recouvrement (130) ; éventuellement dans lequel la couche diélectrique (140) est déposée *ex situ*.

7. Procédé selon l'une quelconque revendication précédente, dans lequel le retrait du matériau (154) déposé sur le masque comprend la planarisation d'une surface de la pièce à usiner.

8. Procédé selon l'une quelconque revendication précédente, dans lequel le matériau de remplissage sacrificiel (160) comprend un matériau de planarisation.

9. Procédé selon l'une quelconque revendication précédente, dans lequel le composant à semi-conducteur (120) comprend une hétérostructure à semi-conducteur permettant d'héberger un gaz d'électrons bidimensionnel ou un gaz de trous bidimensionnel.

10. Procédé selon l'une quelconque revendication précédente, dans lequel :
le composant à semi-conducteur (120) comprend un matériau à semi-conducteur III-V ; et/ou
le matériau déposé (152,154) comprend un supraconducteur.
